# EUROPEAN PATENT SPECIFICATION

(11) **EP 0 473 441 B1**
(45) Date of publication and mention of the grant of the patent: **10.05.1995**
(21) Application number: 91307935.6
(22) Date of filing: 29.08.1991
(51) Int. Cl.: H01S 3/109, H01S 3/1055, G02B 6/10, G11B 7/125

(54) **Harmonic generating apparatus**
Vorrichtung zur Erzeugung von Oberwellen
Dispositif de génération d'harmoniques

(30) Priority: 29.08.1990 JP 227187/90
(43) Date of publication of application: 04.03.1992
(73) Proprietor: Oki Electric Industry Co., Ltd., Tokyo (JP)
(72) Inventor: Shinozaki, Keisuke, c/o Oki Electric Ind. Co. Ltd., Minato-ku, Tokyo (JP); Oshiba, Saeko, c/o Oki Electric Ind. Co. Ltd., Minato-ku, Tokyo (JP); Kamijoh, Takeshi, c/o Oki Electric Ind. Co. Ltd., Minato-ku, Tokyo (JP)
(74) Representative: Read, Matthew Charles

(56) References cited:
- DE-U- 9 102 316
- APPLIED PHYSICS LETTERS. vol. 53, no. 13, 26 September 1988, NEW YORK US pages 1170 - 1171; M.K. CHUN ET AL.: 'Second-harmonic generation at 421 nm using injection-locked GaAlAs laser array and KNbo3'
- OPTICS LETTERS vol. 14, no. 14, 15 July 1989, NEW YORK, US pages 731 - 733; G.J. DIXON ET AL.: 432 nm source based on efficient second-harmonic generation of GaA1As diode-laser radiation in self-locking external resonant cavity'
- OPTICS LETTERS vol. 12, no. 11, November 1987, NEW YORK, US pages 876 - 878; B.DAHMANI ET AL.: 'Frequency stabilization of semiconductor lasers by resonant feedback'
- INSTRUMENTS AND EXPERIMENTAL TECHNIQUES. vol. 15, no. 6, December 1972, NEW YORK US pages 1811 - 1813; YU. A. GOROKHOV ET AL.: 'Extraction of second-harmonic radiation from a laser resonator'
- SOVIET JOURNAL OF QUANTUM ELECTRONICS. vol. 1, no. 5, April 1972, NEW YORK US pages 547 - 549; V.I. KRAVCHENKO ET AL.: 'Frequency tuning and high-efficiency extraction of second-harmonic radiation from a prism dispersion resonator of a neodymium laser'
- APPLIED PHYSICS LETTERS. vol. 55, no. 23, 4 December 1989, NEW YORK US pages 2383 - 2385; S. OSHIBA ET AL.: 'Widely tunable semiconductor optical fiber ring laser'
- PATENT ABSTRACTS OF JAPAN vol. 13, no. 142 (E-739)7 April 1989

## Description

The present invention relates to an apparatus for generating a harmonic, particularly a second-harmonic of a fundamental wave.

An element employed for second-harmonic generation (SHG) is described, for example, in Electronics Letters, Vol. 25, (1989), PP. 731-732. Its operation is based on a quasi-phase matching method.

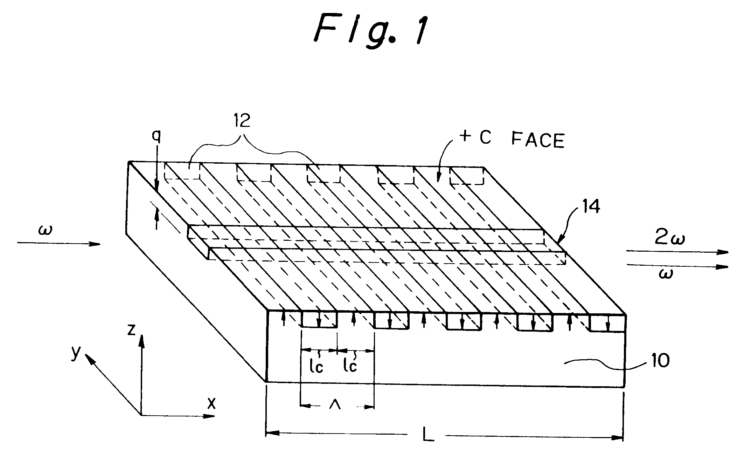

Referring to Figure 1, the quasi-phase matching will be described. Figure 1 shows a waveguide-type SHG element. Titanium is diffused in a shape of strips at +C surface of a LiNbO₃ substrate 10, so that domain-reversal regions 12 are formed with a period Λ. An optical waveguide 14 is formed orthogonally to the domain-regions 12 by a proton exchanging method (Li⁺ - H⁺ exchanging method).

In Figure 1, a fundamental wave (angular frequency; ω, wavelength; λ (ω)) enters the SHG element. The fundamental wave propagates in the light waveguide 14. The propagation energy of the fundamental frequency ; 2 ω, wavelength ; λ (2 ω)).

If the SHG element does not have the domain-reversal regions 12, maximum power of the second harmonic is obtained when the fundamental wave goes up to the coherence length ℓ_{c} according to the following equation (1).${\text{ℓ}}_{\text{c}} \text{=} \frac{\text{λ ( ω )}}{\text{4 ( Nn ( 2ω ) - Nm (ω ))}}$
wherein, Nn(2ω) is an effective guide index of the second harmonic in n-th propagation mode, and Nm(ω) is the index of the fundamental wave in m-th propagation mode.

For example, the coherence length ℓ_{c} is approximately 1.7 »m, when both propagation modes are 0-th (m = n = 0), λ (ω) is 830 nm, and thickness d of the light waveguide 14 is 1 »m.

In this case, the second-harmonic has maximum power at the first 1.7 »m in the wave guide 14, and has none at the next 1.7 »m. That is, even though the fundamental wave goes longer that ℓ_{c}, power of the second-harmonic does not exceed a certain quantity. It comes from an incomplete phase-matching between the fundamental wave and the second-harmonic.

A phase-mismatching Δk is obtained according to the following equation.$\text{Δk =} \frac{\text{4 π}}{\text{λ ( ω )}} \text{( N ( 2ω ) - N ( ω ))}$

In order to correct the phase-mismatching Δk, the domain reversal regions 12 are formed with the period Λ (= 2 ℓ_{c}) as shown in Figure 1. Thereby the second-harmonic has a power approximately in proportion to a square of the propagation length.

For a condition to correct Δk completely, the following equation (2) is indicated in Optics Communications Vol. 6, 1972, pp. 301-302.$\text{N (2ω) - N (ω) - λ (2ω) / Λ = 0}$

Thus, when the domain reversal regions 12 are formed so as to satisfy the equation (2), although the both phases do not match each other, the second harmonic has power in proportion to a square of the SHG element's length L.

However, it is difficult to satisfy the equation (2), since the effective guide indices N(2ω) and N(ω) depend on dimensions of the light waveguide 14 which are difficult to achieve with sufficient accuracy and also the period Λ.

A dye laser is considered for a light source in the literature "Electronics Letters, Vol. 25, (1989), pp. 731-732". Although it is capable of changing its wavelength, the entire apparatus cannot be constructed to be of a compact size.

It is an object of the present invention as claimed in Claim 1 to provide a second-harmonic generating apparatus which is compact and produces a high-power laser light.

According to an embodiment of the present invention, a laser diode is employed for a light source, and is caused to resonate by means of an external arrangement, that may include a diffraction grating. An SHG element is disposed within the resonator arrangement. By controlling the diffraction angle of the grating, the wavelength of the fundamental wave is selected so as to maximise production of the second harmonic.

Therefore it is possible to change the wavelength of the oscillation of the laser diode so as to agree with the phase-matching condition of the SHG element.

Objects and features of the present invention will become more apparent from the consideration of the following detailed description taken in conjunction with the accompanying drawings in which:
Figure 1 is an oblique view of a waveguide-type SHG element employed for the second-harmonic generation;
Figures 2 and 3 are schematic plan views of first and second embodiments according to the invention; and
Figures 4a and 4B relate to modifications of the first and second embodiments according to the invention.

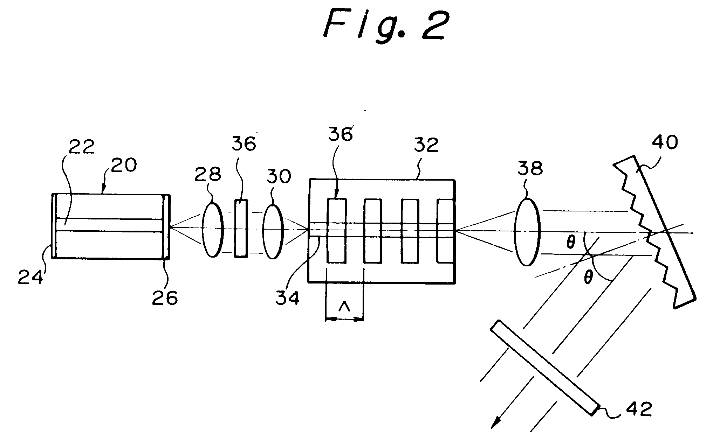

The first embodiment according to the present invention is illustrated in Figure 2.

In Figure 2, the apparatus comprises a semiconductor laser diode 20, a waveguide-type SHG element 32 and an optical reflector 40.

The SHG element 32 has the same structure as the one shown in Figure 1. Thus, equally spaced domain-reversal regions 35 are formed with a period Λ , an optical waveguide 34 is formed orthogonally to the regions 35 LiNbO₃, KTiOPO₄ or other proper substrate is used for the element 32.

The semiconductor laser diode 20 is employed as a light source. The layer diode 20 has a high reflection (HR) coated end-facet 24 and an antirelection (AR) coated end facet 26, at each end of the active region 22. The HR coated end-facet 24 is desired to have 100% reflectance. The reflectance of the AR coated end-facet 26 is preferably less than 10⁻⁴ in order to obtain a high power of a second-harmonic.

Light from the laser diode 20 enters the optical waveguide 34 of the SHG element 32. Since the light is emitted from the AR coated end-facet 26 in TM-mode, it is desired to rotate the electric field polarisation by 90 degrees, using a half-wave plate 35 and thereby the fundamental wave entering to the waveguide 34 has an increased energy. The fundamental wave from the SHG element 32 is collimated by lens 38. Then it impinges upon an optical reflector 40 which has selectivity of reflected wavelength. In the first embodiment, a diffraction grating is employed for the reflector 40. The HR coated end-facet 24 of the laser diode 20 and the diffraction grating 40 constitute an external resonator. An optical filter 42 is employed in order to reduce transmission of the fundamental wave.

Disposing the diffraction grating 40 so as to satisfy the following equation (3), a wavelength λ (ω) of the fundamental wave is defined as an oscillation wavelength of the laser diode 20.$\text{d sin ϑ = λ (ω)}$

wherein d is a lattice constant of the grating 40, and ϑ is a diffraction angle of the grating 40.

Consequently the oscillation wavelength λ (ω) of the laser diode 20 is selected by changing ϑ. Therefore, by controlling ϑ , it is possible to satisfy the condition of quasi-phase matching according to equation (2), because the effective guide indices N(2ω) and N(ω) are functions of the wavelength λ (ω) of the fundamental wave.

The range of the oscillation wavelength achievable by controlling ϑ is within gain-width of the active region 22 of the laser diode 20, and is above 100 nm. In this range, it is possible with current technology to fabricate the SHG element 32 which satisfies the quasi-phase matching condition.

When an upper and a lower electrode (not illustrated) of the laser diode 20 are fed with a prescribed voltage, the laser diode 20 oscillates. Light emitted from the AR coated end-facet 26 enters the waveguide 34 of the SHG element 32 through the optical system (28, 36 and 30). After propagating through the waveguide 34 and the lens 38, the light impinges upon the diffraction grating 40, with the diffraction angle ϑ satisfying the condition of the equation (3).

Part of the light is reflected by the grating 40 back to the laser diode 20. The wavelength of the reflected light is defined as the wavelength λ (ω) of the fundamental wave. As a result, the condition of the equation (2) is satisfied completely. So resonance on the fundamental wave occurs, and laser oscillation with high power is obtained.

While the fundamental wave propagates in the waveguide 34, a part of energy of the fundamental wave is converted to a second-harmonic.

The second-harmonic has a half wavelength (λ(2 ω)) of the fundanental wave.

The second harmonic and non-converted fundamental wave are partially diffracted by the grating 40. The diffracted waves pass out of the resonator, and the second-harmonic is selected by the filter 42.

According to the first embodiment, by controlling the diffraction angle ϑ of the grating 40, it is possible to select the best wavelength of the fundamental wave so as to maximise production of the second harmonic.

In addition, the external resonator consisting of the laser diode 20 and the grating 40 has a couple of cm in its length so that a distance of the oscillation longitudinal-mode is merely 0.001 nm. Thus, actually, the control of the oscillation wavelength can be performed continuously.

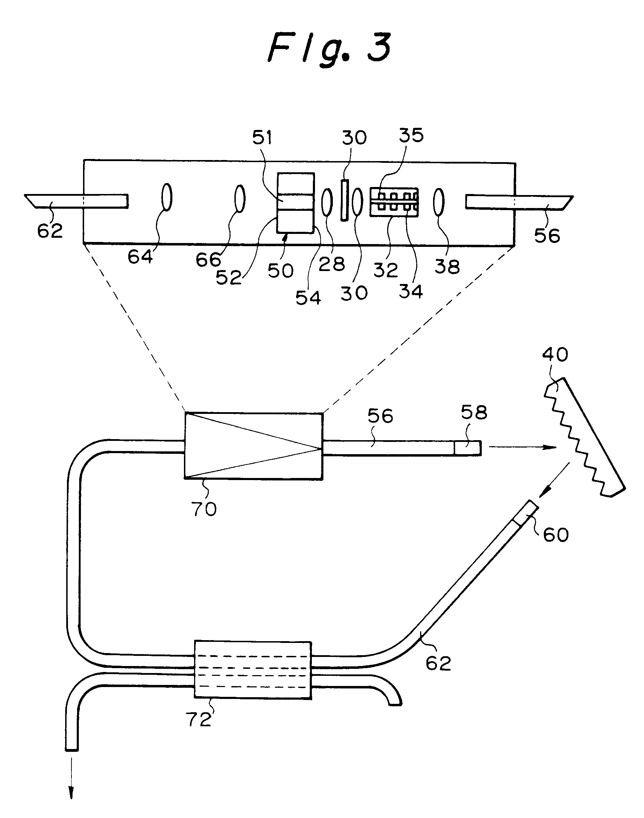

The second embodiment according to the present invention is illustrated in Figure 3. The same reference numbers are used for the same parts as shown in Figure 2.

In Figure 3, a SHG unit 70 comprises a laser diode 50 and the SHG element 32. In the same way as in the first embodiment, the lenses 28, 30 and the half-wave plate 36 are disposed between them. The SHG unit 70, the diffraction grating 40 and optical fibres 56, 60 form a loop resonator.

In the second embodiment, the laser diode 50 has an active region 51 and two AR coated end-facets 52, 54. Although the laser diode 50 does not oscillate by itself, light emitted from the laser diode 50 is fed back through the loop and because of the feedback, laser oscillation occurs.

One end of the optical fibre 56 is coupled to the SHG element 32 through the lens 38, and one end of the optical fibre 62 is coupled to the laser diode 50 through the lenses 64, 66. Both other ends of the optical fibres 56 and 62 are optically connected by the diffraction grating 40 which selects wavelength. Graded index (GRIN) lenses 58 and 60 are arrranged on the ends of the optical fibres 56 and 62 adjacent the grating 40.

The optical fibres 56 and 60 may be of a type keeping a plane of polarisation.

When the laser diode 50 is fed with a prescribed voltage, light emitted from the AR coated end-facet 54 enters the SHG element 32, through the lens 28, half-wave plate 36 and lens 30. The light propagates through the SHG element 32, and enters the optical fibre 56.

Then the light is collimated by the GRIN lens 58 and impinges upon the grating 40. The wavelength-selected light from the grating 40 enters the optical fibre 62 through the GRIN lens 60. The light proceeds through the optical fibre 62 back to the laser diode 50.

A directional coupler 72 is disposed in the middle of the optical fibre 62. Thus, light is taken out from the loop through the directional coupler 72. In addition, by using an optical filter such as the first embodiment, the second-harmonic is selected.

By controlling the diffraction angle ϑ of the grating 40, it is possible to select the best wavelength so as to maximise production of the second-harmonic. The optical fibres employed in the second embodiment are particularly convenient for extracting the second- harmonic.

In addition, since the diffraction grating 40 has high wavelength-selectivity, it is possible to make narrow a spectral full width at half maximum (FWHM) for the fundamental wave e.g. less than 1 nm.

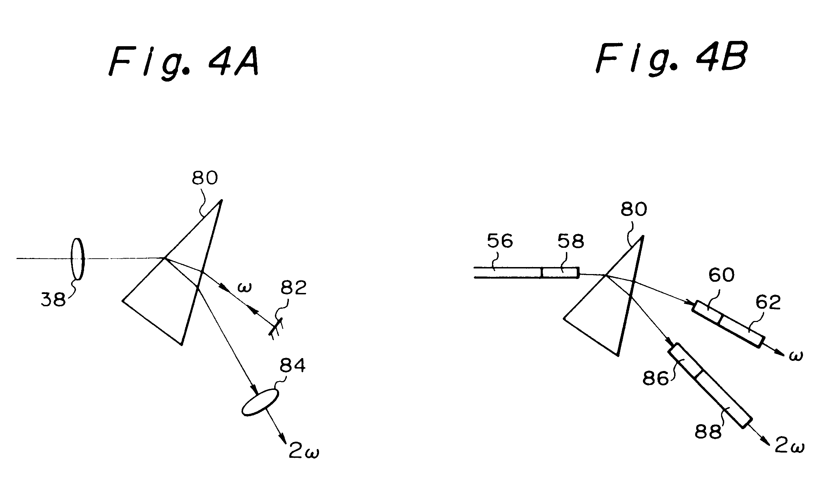

Referring to Figures 4A and 4B, modifications of the first and second embodiments will be described. They employ a prism instead of the diffraction grating for selecting a wavelength; these figures show only the part of the apparatus used for wavelength selection.

Figure 4A shows the modification of the first embodiment. By using a prism 80, the fundamental wave (ω) and the second-harmonic (2ω) are separated completely. A mirror 82 reflecting the fundamental wave is utilised to form the external resonator. A lens 84 may be employed for the second-harmonic.

Figure 4B shows the modification of the second embodiment. The prism 80 separates the fundamental wave (ω) and the second-harmonic (2ω). These waves are respectively introduced to the optical fibres 62 and an additional optical fibre 88. The fibre 88 may have a GRIN lens 60 at the introducing end.

As described above, according to the present invention, it is possible to select the wavelength of oscillation of the laser diode so as to agree with the phase-matching conditon of the SHG element. Therefore, although the dimensions of the SHG element need not be accurate per se, quasi-phase matched SHG can be realised by the technique of the fundamental wave selection.

Further, since a laser diode is employed for the light source, a compact apparatus can be provided.

The second-harmonic generating apparatus according to the present invention can be used in an optical recorder, an interferometer or other apparatus which needs light having a short wavelength and high-power.

## Claims

1. Harmonic generating apparatus comprising:
laser means (20, 50) for producing laser radiation at a fundamental frequency;
feedback means (40, 62, 80, 82) feeding said laser radiation at the fundamental frequency back to the laser means (20, 50); and
a harmonic generating element (32) for generating a predetermined harmonic of said fundamental frequency disposed between said laser means and said feedback means; **characterised in that**
the harmonic generating element (32) is of a quasi phase-matching type and the feedback means (40, 62, 80, 82) includes wavelength selective tuning means controlled such that the fundamental frequency is adjusted for optimum quasi phase-matching in the harmonic generating element (32).

2. An apparatus according to claim 1, wherein said predetermined harmonic is twice the fundamental frequency.

3. An apparatus according to claim 1 or 2, wherein the laser means (20, 50) is a laser diode (20) having an anti-reflection coating on one end facet and a high reflectivity coating on the other end facet which is directed away from the harmonic generating means (32).

4. An apparatus according to claim 3, wherein the tuning means (40, 80, 82) comprises a diffraction grating (40).

5. An apparatus according to claim 3, wherein the tuning means (40, 80, 82) comprises a prism and a mirror, the mirror (82) forming an optical resonator with said high reflectivity coated end facet.

6. An apparatus according to claim 1 or 2, wherein the laser means (20, 50) comprises a laser diode (50) having an anti-reflection coating on both end facets, and comprising a first optical fibre (56) leading between the harmonic generating element (32) and the tuning means (40, 80, 82) and a second optical fibre (62) leading between the tuning means (40, 80, 82) and the end facet of the laser diode directed away from the harmonic generating element (32).

7. An apparatus according to claim 6, wherein the tuning means (40, 80, 82) comprises a diffraction grating (40).

8. An apparatus according to claim 6, wherein the tuning means (40, 80, 82) comprises a prism (80) and a mirror (82), the mirror (82) forming an optical resonator with said high reflectivity coated end facet.

9. An apparatus according to any preceding claim, wherein the harmonic generating element (32) is a waveguide structure.

## Patentansprüche

1. Vorrichtung zur Erzeugung einer Harmonischen, mit:
einer Lasereinrichtung (20, 50) zur Erzeugung von Laserstrahlung mit einer Grundfrequenz;
einer Rückkopplungseinrichtung (40, 62, 80, 82), die die Laserstrahlung mit der Grundfrequenz an die Lasereinrichtung (20,50) rückkoppelt, und
einem Element (32) zur Erzeugung einer Harmonischen, zur Erzeugung einer vorbestimmten Harmonischen der Grundfrequenz, das zwischen der Lasereinrichtung und der Rückkopplungseinrichtung angeordnet ist;
dadurch gekennzeichnet, daß
das Element (32) zur Erzeugung einer Harmonischen ein Quasi-Phasenanpassungs-Typ ist und die Rückkopplungseinrichtung (40, 62, 80, 82) eine wellenlängenselektive Abstimmeinrichtung umfaßt, die so gesteuert wird, daß die Grundfrequenz für eine optimale Quasi-Phasenanpassung im Element (32) zur Erzeugung einer Harmonischen eingestellt wird.

2. Vorrichtung gemäß Anspruch 1, wobei die vorbestimmte Harmonische die doppelte Grundfrequenz ist.

3. Vorrichtung gemäß Anspruch 1 oder 2, wobei die Lasereinrichtung (20,50) eine Laserdiode (20) ist, die eine Antireflexions-Beschichtung auf einer Endfacette und eine hochreflektive Beschichtung auf der anderen Endfacette aufweist, welche von der Einrichtung (32) zur Erzeugung einer Harmonischen weg gerichtet ist.

4. Vorrichtung gemäß Anspruch 3, wobei die Abstimmeinrichtung (40, 80, 82) ein Beugungsgitter (40) aufweist.

5. Vorrichtung gemäß Anspruch 3, wobei die Abstimmeinrichtung (40, 80, 82) ein Prisma und einen Spiegel aufweist, wobei der Spiegel (82) mit der hochreflektiv beschichteten Endfacette einen optischen Resonator bildet.

6. Vorrichtung gemäß Anspruch 1 oder 2, wobei die Lasereinrichtung (20,50) eine Laserdiode (50) mit einer Antireflexions-Beschichtung auf beiden Endfacetten aufweist, und mit einer ersten Lichtleitfaser (56), die zwischen dem Element (32) zur Erzeugung einer Harmonischen und der Abstimmeinrichtung (40, 80, 82) leitet, und einer zweiten Lichtleitfaser (62), die zwischen der Abstimmeinrichtung (40, 80, 82) und der Endfacette der Laserdiode leitet, die von dem Element (32) zur Erzeugung einer Harmonischen weg gerichtet ist.

7. Vorrichtung gemäß Anspruch 6, wobei die Abstimmeinrichtung (40, 80, 82) ein Beugungsgitter (40) aufweist.

8. Vorrichtung gemäß Anspruch 6, wobei die Abstimmeinrichtung (40,80,82) ein Prisma (80) und einen Spiegel (82) aufweist, wobei der Spiegel (82) mit der hochreflektiv beschichteten Endfacette einen optischen Resonator bildet.

9. Vorrichtung gemäß einem der vorstehenden Ansprüche, wobei das Element (32) zur Erzeugung einer Harmonischen ein Wellenleitergebilde ist.

## Revendications

1. Appareil générateur d'harmoniques comprenant:
un moyen (20,50) à laser pour produire un rayonnement laser à une fréquence fondamentale;
un moyen (40, 62, 80, 82) à rétroaction renvoyant ledit rayonnement à la fréquence fondamentale vers le moyen (20, 50) à laser; et
un élément (32) générateur d'harmoniques pour générer un harmonique prédéterminé de ladite fréquence fondamentale, disposé entre ledit moyen à laser et ledit moyen à rétroaction;
caractérisé en ce que
l'élément (32) générateur d'harmoniques est du type à quasi-adaptation de phase et le moyen (40, 62, 80, 82) à rétroaction comporte un moyen d'accord sélectif en longueur d'onde commandé de façon que la fréquence fondamentale soit ajustée pour une quasi-adaptation de phase optimale dans l'élément (32) générateur d'harmoniques.

2. Appareil selon la revendication 1, dans lequel ledit harmonique prédéterminé est le double de la fréquence fondamentale.

3. Appareil selon les revendications 1 ou 2, dans lequel le moyen (20, 50) à laser est une diode (20) laser ayant un revêtement antiréfléchissant sur une facette d'extrémité et un revêtement à réflectivité élevée sur l'autre facette d'extrémité qui est dirigée dans une direction opposée au moyen (32) générateur d'harmoniques.

4. Appareil selon la revendication 3, dans lequel le moyen (30, 80, 82) d'accord comprend un réseau (40) de diffraction.

5. Appareil selon la revendication 3, dans lequel le moyen (40, 80, 82) d'accord comprend un prisme et un miroir, le miroir (82) formant un résonateur optique avec ladite facette d'extrémité revêtue à réflectivité élevée.

6. Appareil selon les revendications 1 ou 2, dans lequel le moyen (20, 50) à laser comprend une diode (50) à laser ayant un revêtement antiréfléchissant sur les deux facettes d'extrémité, et comprenant une première fibre (56) optique reliée entre l'élément (32) générateur d'harmoniques et le moyen (40, 80, 82) d'accord et une deuxième fibre (62) optique reliée entre le moyen (40, 80 82) d'accord et la facette d'extrémité de la diode laser dirigée dans une direction opposée à l'élément (32) générateur d'harmoniques.

7. Appareil selon la revendication 6, dans lequel le moyen (40, 80, 82) d'accord comprend un réseau (40) de diffraction.

8. Appareil selon la revendication 6, dans lequel le moyen (40, 80, 82) d'accord comprend un prisme (80) et un miroir (82), le miroir (82) formant un résonateur optique avec ladite facette d'extrémité revêtue à réflectivité élevée.

9. Appareil selon l'une quelconque des revendications précédentes, dans lequel l'élément (32) générateur d'harmoniques est une structure à guide d'ondes.
